# EUROPEAN PATENT APPLICATION

(11) **EP 2 597 653 A1**
(43) Date of publication of application: **29.05.2013**
(21) Application number: 11809673.4
(22) Date of filing: 20.07.2011
(51) Int. Cl.: H01B 7/00, H01B 7/17, B60R 16/02

(54) **WIRE HARNESS**

(30) Priority: 23.07.2010 JP 2010165489
(71) Applicant: Yazaki Corporation, Minato-ku Tokyo 108-8333 (JP)
(72) Inventor: TOYAMA Eiichi, Shizuoka (JP)
(74) Representative: Grünecker, Kinkeldey, Stockmair & Schwanhäusser
(86) International application number: PCT/JP2011/066480
(87) International publication number: WO 2012/011503

(57) **Abstract**

In order to provide with a wire harness capable of magnetic shielding for reducing restrictions of path design, a wire harness 21 is configured to include a wire harness body 23, connections 24 respectively formed on both ends of this wire harness body 23, and an exterior member 25 for protecting the wire harness body 23. The wire harness body 23 is configured to include two high-voltage electric wires 26, an electromagnetic shielding member 27 for collectively receiving the two high-voltage electric wires 26, and a magnetic shielding member 28 formed on the outside of the electromagnetic shielding member 27. The magnetic shielding member 28 is formed in a desired place. The wire harness body 23 combines both functions of electromagnetic shielding and magnetic shielding.

## Description

### <Technical Field>

The present invention relates to a wire harness formed by combining both functions of electromagnetic shielding and magnetic shielding.

### <Background Art>

Plural high-voltage electric wires are used in electrical connection between a battery and an inverter in an electric vehicle or a hybrid vehicle. For example, in the following Patent Reference 1, in plural high-voltage electric wires, an intermediate part of this electric wire is cabled to a vehicle under-floor part and also both ends of the electric wire extend through a vehicle frame and are cabled to an engine room of the front of the vehicle or the rear of the vehicle. Each of the plural high-voltage electric wires is inserted into a metal protective pipe and is protected over the whole length.

### <Prior Art Reference>

### <Patent Reference>

Patent Reference 1: JP-A-2004-224156

### <Disclosure of the Invention>

### <Problems that the Invention is to Solve>

The conventional art described above finds that workability of cabling is not good since it is necessary to do, for example, work of fixing to the vehicle under-floor part or work of extending through the vehicle frame as cabling of the plural high-voltage electric wires. The present inventor contemplates cabling to the inside of a vehicle room without the need to do work of penetration.

Cabling of the high-voltage electric wires to the inside of the vehicle room has fear that the high-voltage electric wires exert an influence of electromagnetic noise on, for example, low-voltage electric wires cabled to the vicinity inside the same vehicle room or electronic devices installed inside the same vehicle room. Consequently, it is necessary to provide the high-voltage electric wire with an electromagnetic shielding member for electromagnetic shielding. Also, since a current flowing through the high-voltage electric wire is a current (a current having a relatively high frequency) constantly changing with time, there is fear of exerting an influence on, for example, a passenger of the inside of the vehicle room depending on a produced magnetic field. Consequently, it becomes necessary to take measures to, for example, provide all or a part of the floor with an iron plate having a magnetic shielding function.

Hence, in the case of considering that the high-voltage electric wire is provided with the electromagnetic shielding member and also the floor is provided with the iron plate separately from the high-voltage electric wire, the iron plate particularly has the following problem. That is, the iron plate has the problem of restricting path design of the high-voltage electric wire though the iron plate enables shielding from a magnetic field produced by the high-voltage electric wire.

The invention has been implemented in view of the circumstances described above, and an object of the invention is to provide a wire harness capable of magnetic shielding for reducing restrictions of path design.

### <Means for Solving the Problems>

The object of the invention is achieved by the following configuration. (1) A wire harness, comprising one or plural conducting paths, an electromagnetic shielding member for electromagnetic shielding, the electromagnetic shielding member covering the conducting paths, and a magnetic shielding member for magnetic shielding, the magnetic shielding member formed outside or inside of the electromagnetic shielding member.

(2) In the wire harness with the configuration of the above (1), a wire harness wherein the magnetic shielding member is formed of at least one of a metal foil and a magnetic shielding sheet or is formed of a tape material including the metal foil.

(3) In the wire harness with the configuration of the above (2), a wire harness wherein the magnetic shielding member is formed by one or plural winds.

According to the wire harness with the configuration of the above (1), the magnetic shielding member for magnetic shielding is included in the configuration, so that the wire harness has an effect capable of reducing restrictions of path design as compared with the case of magnetic shielding by a separate body such as an iron plate of a floor. Accordingly, there is an effect capable of providing the better wire harness for combining both functions of electromagnetic shielding and magnetic shielding.

The wire harness with the configuration of the above (2) or (3) has an effect capable of providing a better mode as the magnetic shielding member.

### <Brief Description of the Drawings>

[Fig. 1] Figs. 1(a) to 1(c) are diagrams showing a wire harness according to one embodiment of the invention, and Fig. 1(a) is a schematic diagram of a vehicle, and Fig. 1(b) is a configuration diagram of the wire harness, and Fig. 1(c) is a main sectional diagram of the wire harness.
[Fig. 2] Figs. 2(a) to 2(f) are diagrams according to magnetic shielding characteristics.

### <Mode for Carrying Out the Invention>

One embodiment will hereinafter be described with reference to the drawings.
A wire harness cabled to a hybrid vehicle or an electric vehicle is targeted for a wire harness of the present embodiment. The wire harness is configured to include a shielding member of the embodiment. Hereinafter, an example in the hybrid vehicle shall be given and described. (For the electric vehicle, a configuration, a structure and an effect of the wire harness and the shielding member of the embodiment are basically the same. In addition, the embodiment is not limited to the hybrid vehicle or the electric vehicle, and can also be applied to typical vehicles etc.)

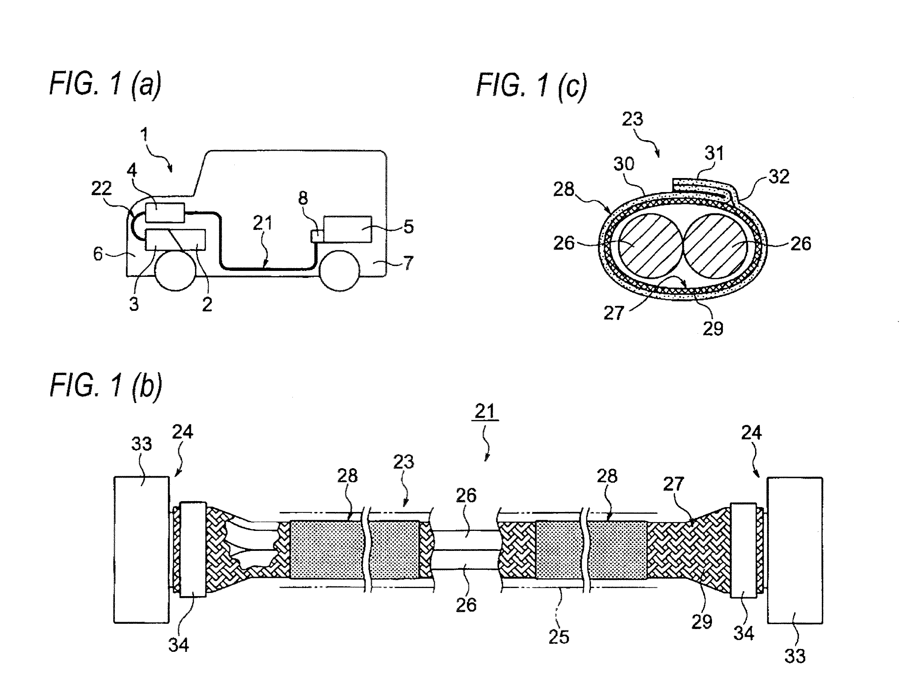

In Fig. 1(a), reference numeral 1 shows a hybrid vehicle. The hybrid vehicle 1 is a vehicle driven by mixing two powers of an engine 2 and a motor unit 3, and is constructed so that electric power from a battery 5 (a battery pack) is supplied to the motor unit 3 through an inverter unit 4. The engine 2, the motor unit 3 and the inverter unit 4 are installed in an engine room 6 of a position having front wheels etc. in the embodiment. Also, the battery 5 is installed in a vehicle rear part 7 having rear wheels etc. (may be installed inside a room of the vehicle present in the rear of the engine room 6).

The inverter unit 4 is connected to the battery 5 by a high-voltage wire harness 21 according to the embodiment. Also, the inverter unit 4 is connected to the motor unit 3 by a high-voltage wire harness 22. The wire harness 21 is cabled to the room inside of a floor panel. The wire harness 21 is manufactured in a long shape. On the other hand, the wire harness 22 is the so-called motor cable, and is manufactured in a shape remarkably shorter than that of the wire harness 21. In addition, in the wire harness 22 of the embodiment, a publicly known motor cable is used, but the invention may be applied without being limited to this motor cable.

Supplemental explanation of the embodiment is given herein. The motor unit 3 includes a motor and a generator in a configuration. Also, the inverter unit 4 includes an inverter and a converter in a configuration. The motor unit 3 is formed as a motor assembly including a shield case. Also, the inverter unit 4 is formed as an inverter assembly including a shield case. The battery 5 is a battery of a Ni-MH system or a Li-ion system, and is formed by modularization. In addition, an electric storage device such as a capacitor can be used. The battery 5 is not particularly limited as long as the battery 5 can be used in the hybrid vehicle 1 or the electric vehicle. The battery 5 is connected to the wire harness 21 through a junction block 8 in the embodiment.

As shown in Fig. 1(b), the wire harness 21 for making connection between the battery 5 and the inverter unit 4 is configured to include a wire harness body 23, connections 24 respectively formed on both ends of this wire harness body 23, and an exterior member 25 for protecting the wire harness body 23. Each component will hereinafter be described.

The wire harness body 23 is configured to include two high-voltage electric wires 26 (conducting paths), an electromagnetic shielding member 27 for collectively receiving the two high-voltage electric wires 26, and a magnetic shielding member 28 formed on the outside (or the inside) of the electromagnetic shielding member 27.

The magnetic shielding member 28 is formed in a desired place in the embodiment. The magnetic shielding member 28 may be formed in one place in addition to plural places. Also, the whole electromagnetic shielding member 27 may be covered with the magnetic shielding member 28. Moreover, the number of high-voltage electric wires 26 is not limited to two.

In the wire harness 21, the wire harness body 23 combines both functions of electromagnetic shielding and magnetic shielding.

The high-voltage electric wire 26 is a conducting path including a conductor and an insulator (coating), and is formed so as to have a length necessary for electrical connection. The conductor is made of copper, copper alloy or aluminum. The conductor has a conductor structure formed by twisting strands or bar-shaped conductor structure with a rectangular or circular cross section (for example, a conductor structure with a rectangular or circular single core and in this case, the electric wire itself also has a bar shape), and may have any of the conductor structures. The high-voltage electric wire 26 has a configuration of an electric wire without shielding.

The embodiment uses the high-voltage electric wire 26 as the conducting path, but is not limited to this high-voltage electric wire 26. That is, a bus bar may be used, or in the case of typical vehicles etc., a low-voltage electric wire bundle may be used.

The electromagnetic shielding member 27 is a member for electromagnetic shielding (a member for measures against electromagnetic waves), and the two high-voltage electric wires 26 are covered with the electromagnetic shielding member 27, and the electromagnetic shielding member 27 is formed in a tubular shape by a braid 29 having multiple ultrathin strands having conductivity. The electromagnetic shielding member 27 is formed in substantially the same length as the whole length of the two high-voltage electric wires 26.

In the embodiment, the electromagnetic shielding member 27 is formed by the braid 29, but the embodiment is not limited to this braid 29. That is, as long as measures against electromagnetic waves can be taken, for example, a metal foil single body or a shielding member configured to include metal foil may be used.

The magnetic shielding member 28 formed on the electromagnetic shielding member 27 as described above is included in order to prevent an influence due to a magnetic field. This is because a current flowing through the high-voltage electric wire 26 is a current (a current having a relatively high frequency) constantly changing with time, with the result that the magnetic field is produced.

The magnetic shielding member 28 is formed in a place in which at least magnetic shielding is required. In the embodiment, the magnetic shielding member 28 is formed in plural places, but the embodiment is not limited to this. That is, the magnetic shielding member 28 may be formed over the whole electromagnetic shielding member 27.

The magnetic shielding member 28 is formed of a metal foil, a magnetic shielding sheet or combinations of the metal foil and the magnetic shielding sheet. As concrete names, aluminum foil, a copper foil sheet, an iron foil sheet, a high-µ sheet, a permalloy foil, etc. are given. The magnetic shielding member 28 is formed by one or plural winds. In the embodiment, the foil or the sheet is wound by at least one round by an overlap wind with a cross-sectional shape shown in Fig. 1(c).

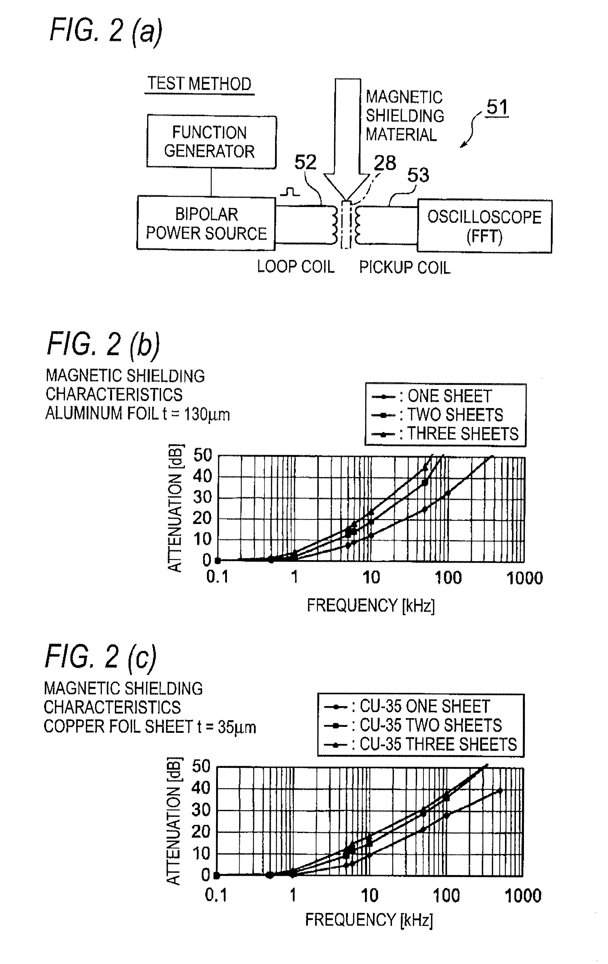

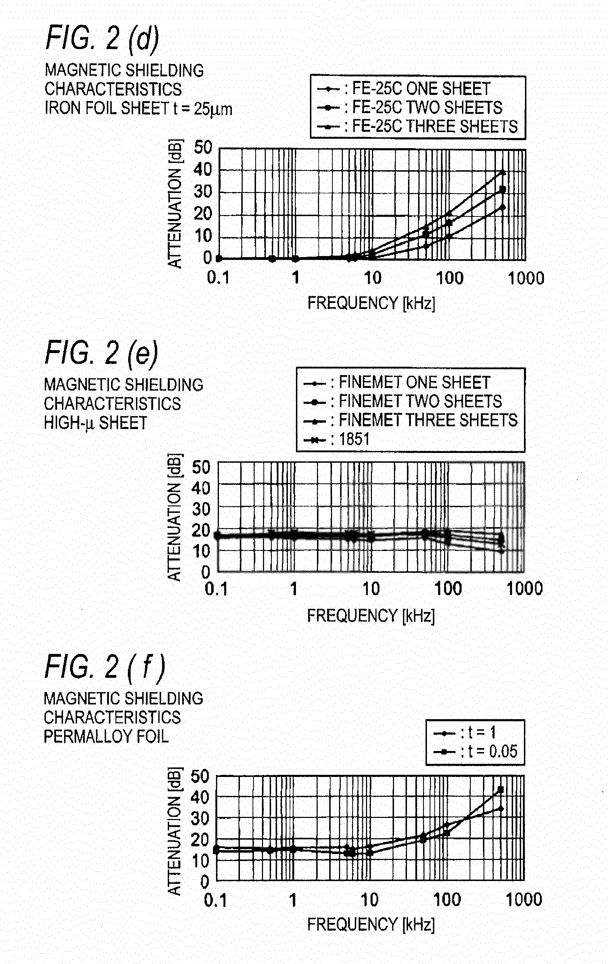

In addition, the overlap wind shows one example in the case of forming the magnetic shielding member 28. The number of winds or the number of laminations is properly set in consideration of attenuation from magnetic shielding characteristics etc. shown in Figs. 2(b) to 2(f). The attenuation of Figs. 2(b) to 2(f) is measured using a tester 51 with a configuration shown in Fig. 2(a). Concretely, the attenuation is measured by inserting the magnetic shielding member 28 between a loop coil 52 and a pickup coil 53 of the tester 51.

For example, in the case of the magnetic shielding member 28 using three copper foil sheets with a thickness of 35 µm, it is found that an attenuation of about 20 dB is obtained at a frequency of 10 kHz as shown in Fig. 2(c). That is, it is found that an effect of shielding of about 20 dB is obtained. In Figs. 2(b) to 2(f), each of the magnetic shielding characteristics according to aluminum foil, a copper foil sheet, an iron foil sheet, a high-µ sheet and a permalloy foil is given, but is not limited to these foils and sheets.

Returning to Fig. 1(c), when the overlap wind described above is formed, the magnetic shielding member 28 is constructed so as to form a tubular part 30 by which the electromagnetic shielding member 27 is surrounded, and an overlap part 31 forming an overlap portion. Also, the magnetic shielding member 28 is constructed so that this overlap part 31 is formed along the tubular part 30 when the overlap part 31 is inclined to one side so as to fold the proximal end 32 of the overlap part 31.

In addition, the magnetic shielding member 28 may be used by forming this magnetic shielding member 28 in a tape shape. In the case of being in the tape shape, the magnetic shielding member 28 is also allowed to function as a binding member.

The connection 24 is configured to include a terminal (not shown) formed on each distal end of the two high-voltage electric wires 26, and a shield shell 33 fixed to a shield case of the battery 5 or the inverter unit 4. The shield shell 33 is a metal member having conductivity, and the distal end of the electromagnetic shielding member 27 is connected and fixed to the shield shell 33 by crimping in the embodiment. Reference numeral 34 shows a crimp ring.

The exterior member 25 for protecting the wire harness body 23 in the wire harness 21, and a publicly known corrugated tube, a pipe member, a protector, etc. are given. In addition, setting of the exterior member 25 is optional. The exterior member 25 has a structure capable of being fixed to a vehicle body.

When the electromagnetic shielding member 27 collectively receives the two high-voltage electric wires 26 and also the magnetic shielding member 28 is formed in a desired position of the outside (or the inside) in the electromagnetic shielding member 27 in the configuration described above, assembly of the wire harness body 23 is completed. Also, when this wire harness body 23 is provided with the connections 24 and the exterior member 25, assembly of the wire harness 21 is completed.

As described above with reference to Figs. 1(a) to 2(f), the wire harness 21 of the embodiment enables magnetic shielding by itself, so that it is unnecessary to take, for example, large-scale measures to form an iron plate on all or a part of the floor of hybrid vehicle 1. Also, in the wire harness 21 of the embodiment, the magnetic shielding member 28 can be formed in a place in which magnetic shielding is desired, and also according to a frequency, metal foil etc. can be used properly, or a thickness or the number of laminations can be changed. Further, in the wire harness 21 of the embodiment, the magnetic shielding member 28 is formed of a metal foil etc. and also the electromagnetic shielding member 27 is formed by the braid 29, so that the wire harness 21 naturally has flexibility and can easily be bent in any direction. Furthermore, in an assembly step of the wire harness 21 of the embodiment, the magnetic shielding member 28 can be wound later, so that workability can be improved.

According to the wire harness 21 of the embodiment, in addition to the electromagnetic shielding member 27, the magnetic shielding member 28 for magnetic shielding is included in a configuration, so that the wire harness 21 has an effect capable of facilitating path design. The embodiment has an effect capable of providing the better wire harness 21.

The wire harness of the invention has been described above in detail with reference to the specific embodiment, but in the embodiment described above, various changes can naturally be made without departing from the gist of the invention.
The present application is based on Japanese patent application (patent application No. 2010-165489) filed on July 23, 2010, and the contents of the patent application are hereby incorporated by reference.

### <Industrial Applicability>

According to the invention, a wire harness including a magnetic shielding member for magnetic shielding in a configuration is obtained. Also, the wire harness combines both functions of electromagnetic shielding and magnetic shielding.

### <Description of Reference Numerals and Signs>

1 HYBRID VEHICLE
2 ENGINE
3 MOTOR UNIT
4 INVERTER UNIT
5 BATTERY
6 ENGINE ROOM
7 VEHICLE REAR PART
8 JUNCTION BLOCK
21,22 WIRE HARNESS
23 WIRE HARNESS BODY
24 CONNECTION
25 EXTERIOR MEMBER
26 HIGH-VOLTAGE ELECTRIC WIRE (CONDUCTING PATH)
27 ELECTROMAGNETIC SHIELDING MEMBER
28 MAGNETIC SHIELDING MEMBER
29 BRAID
30 TUBULAR PART
31 OVERLAP PART
32 PROXIMAL END
33 SHIELD SHELL
34 CRIMP RING

## Claims

1. A wire harness, comprising:
one or plural conducting paths;
an electromagnetic shielding member for electromagnetic shielding, the electromagnetic shielding member covering the conducting paths; and
a magnetic shielding member for magnetic shielding, the magnetic shielding member formed outside or inside of the electromagnetic shielding member.

2. The wire harness as claimed in claim 1, wherein the magnetic shielding member is formed of at least one of a metal foil and a magnetic shielding sheet or is formed of a tape material including the metal foil.

3. The wire harness as claimed in claim 2, wherein the magnetic shielding member is formed by one or plural winds.
